# EUROPEAN PATENT SPECIFICATION

(11) **EP 4 326 998 B1**
(45) Date of publication and mention of the grant of the patent: **30.04.2025**
(21) Application number: 22712667.9
(22) Date of filing: 24.03.2022
(51) Int. Cl.: F16F 1/02, F16F 15/073, F16F 15/00, H02N 2/18, G01P 15/08, G01P 15/09, B81B 3/00, H10N 30/30

(54) **A COMPLIANT STRUCTURE**
NACHGIEBIGE STRUKTUR
STRUCTURE SOUPLE

(30) Priority: 21.04.2021 NL 2028025
(43) Date of publication of application: 28.02.2024
(73) Proprietor: Technische Universiteit Delft, 2628 CN Delft (NL)
(72) Inventor: BLAD, Thijs Willem Albert, 2600 AA DELFT (NL); HERDER, Justus Laurens, 2600 AA Delft (NL)
(74) Representative: van Breda, Jacobus
(86) International application number: PCT/NL2022/050161
(87) International publication number: WO 2022/225390

(56) References cited:
- WO-A1-2017/086785
- US-A- 5 396 797
- US-A1- 2013 038 175
- US-A1- 2015 145 376
- US-A1- 2020 228 032
- US-B2- 9 581 614

## Description

The invention relates to a compliant structure comprising a frame, a shuttle distant from the frame and mounted on a cantilever that is supported by the frame, wherein the cantilever with the shuttle is movable transversely to and out of a plane of the frame, and wherein the structure further comprises one or more flexures that connect the cantilever with the frame.

WO2017086785A1 discloses an ortho-planar spring, comprising a frame and a shuttle that is perpendicularly movable with respect to the frame, wherein flexible members connect the shuttle to the frame, and wherein in an unloaded condition the frame, the flexible members and the shuttle provide the spring with a flat configuration.

US2013/0038175 discloses a compliant structure comprising a frame, a shuttle distant from the frame mounted on a cantilever that is supported by the frame, wherein the cantilever with the shuttle is movable transversely to and out of a plane of the frame, and wherein the structure further comprises one or more flexures that connect the cantilever with the frame, wherein the cantilever has a body at least in part extending in a first direction which points to the shuttle, and that the one or more flexures connect to the shuttle and/or to the cantilever in the vicinity of the shuttle, wherein the flexures are oriented in a second direction, which second direction is generally transversely with respect to the first direction.

According to the invention the flexures are preloaded causing the flexures to buckle so as to provide a selectable stiffness to the cantilever and to provide the cantilever with a preferential position out of the plane of the frame.

The cantilever may be straight, but it may also have another configuration, such as zigzag shape or a tapered shape.

With the structure of the invention the Eigen frequency of the structure can be remarkably reduced and the mechanical efficiency and the range of motion of the cantilever can be improved. It is also possible that the out of plane stiffness of the cantilever can be fully compensated such that static balancing can be achieved.

Advantageously the manufacturing cost of the structure of the invention and be kept low by implementing the structure as a unitary MEMS structure.

Preferably the cantilever of the compliant structure of the invention is piezoelectric. Motion of the cantilever translates then to electric power, which makes possible that the structure of the invention can be used for energy harvesting. However also other applications are feasible such as use as an oscillator, an accelerometer, a geophone, a microphone, a force sensor.

Beneficially the frame is clamped between a top package element and a bottom package element so as to provide the required sturdiness to the construction.

The invention will hereinafter be further elucidated with reference to the drawing of an exemplary embodiment of a structure according to the invention that is not limiting as to the appended claims.

In the drawing:
- figures 1A and 1B show a schematic drawing of the structure of the invention in an isometric view without nonessential parts;
- figure 2 shows a top view at the structure of the invention;
- figure 3 shows the structure of the invention in exploded view;
- figures 4A and 4B show the structure of the invention in an assembled state;
- figure 5A and figure 5B show the structure of the invention wherein the cantilever has a zigzag shape; and
- figure 6 shows the structure of the invention with a variation in the orientation of the flexures.

Whenever in the figures the same reference numerals are applied, these numerals refer to the same parts.

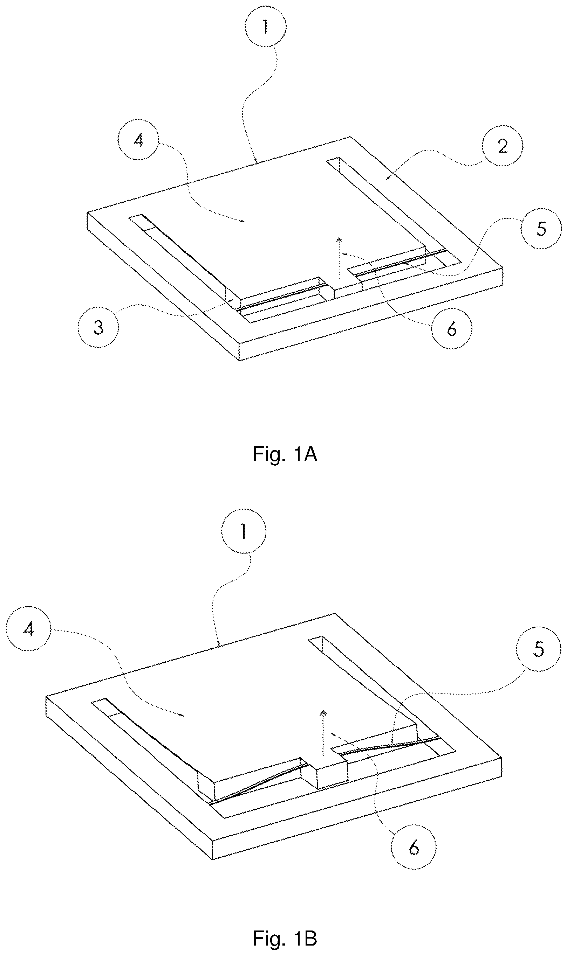

Figure 1A shows the structure 1 of the invention in an unloaded situation, whereas figure 1B shows the structure of the invention in an loaded situation.

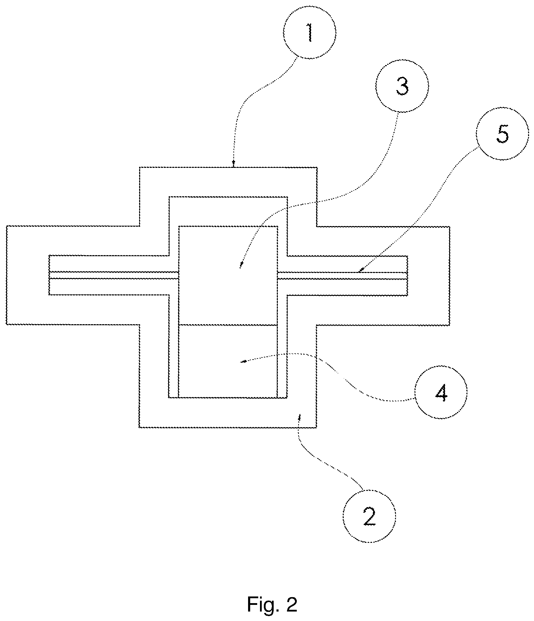

The structure 1 comprises a frame 2, a shuttle 3 distant from the frame 2 mounted on a cantilever 4 that is supported by the frame 2, wherein the cantilever 4 with the shuttle 3 is movable transversely out of a plane of the frame 2, as is depicted in figure 1A and figure 1B. The structure 1 further comprises one or more flexures 5 that connect the cantilever 4 with the frame 2, resulting in a degree of freedom out of plane of the frame 2 as depicted by the axis 6 shown in figure 1B. One thing and another is also shown in figure 2, wherein the degree of freedom is of course not shown since that is perpendicular to the sheet of the drawing.

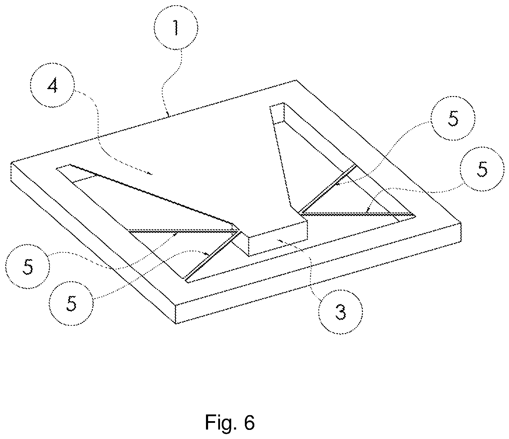

As will be understood from figures 1A/1B and 2 the cantilever 4 has a body extending in a first direction away from where the cantilever 4 is supported by the frame 2 and pointing to the shuttle 3. The one or more flexures 5 connect to the shuttle 3 -as may be best seen in figure 2- and/or to the cantilever in the vicinity of the shuttle, wherein the flexures 5 are oriented in a second direction, which second direction is in this embodiment generally at right angles with respect to the first direction of the cantilever body. A generally transverse orientation of the second direction with respect to the first direction that is not exactly at right angles is however also possible. An example thereof is shown in figure 6.

The flexures 5 are preloaded causing the flexures to buckle and to provide a selectable stiffness to the cantilever 4 and to provide the cantilever 4 with a preferential position out of the plane of the frame 2. Accordingly the cantilever 4 represents a bi-stable system.

The structure of the invention is preferably a unitary MEMS structure, but it is also possible to construe the structure with 3D printing and laser micro-machining.

For particular applications it is preferable that the cantilever is piezoelectric. This makes the structure particularly suitable as a micro-energy harvester.

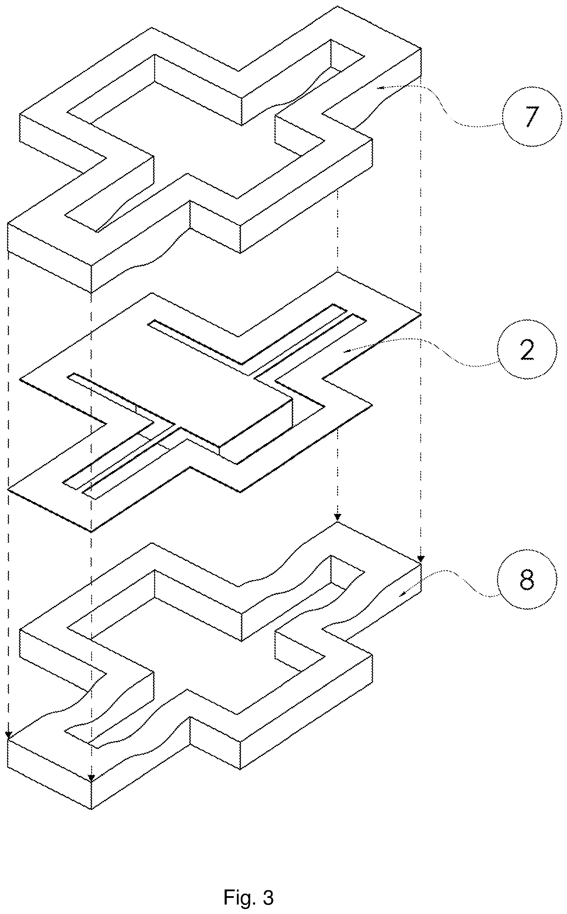

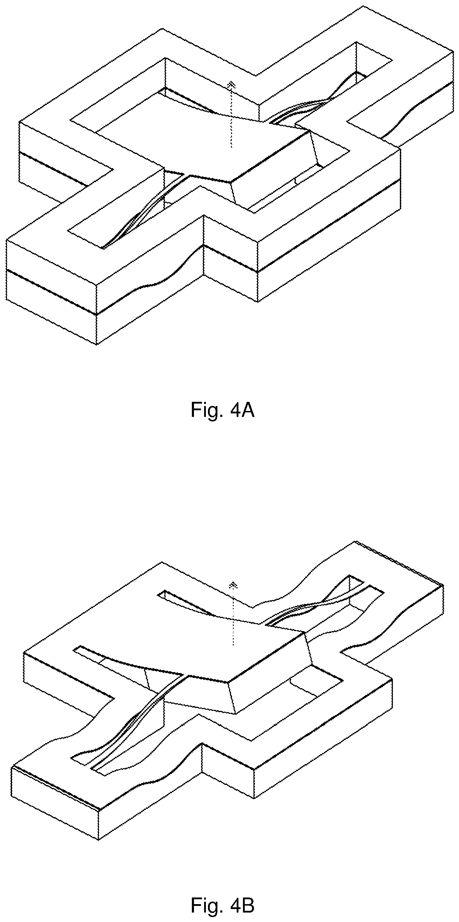

For practical applications it is desirable that the frame 2 is clamped between a top package element 7 and a bottom package element 8. An exploded view thereof is provided by figure 3, whereas same in assembled state is shown in figure 4A. Figure 4B corresponds with figure 4A without the top package element 7.

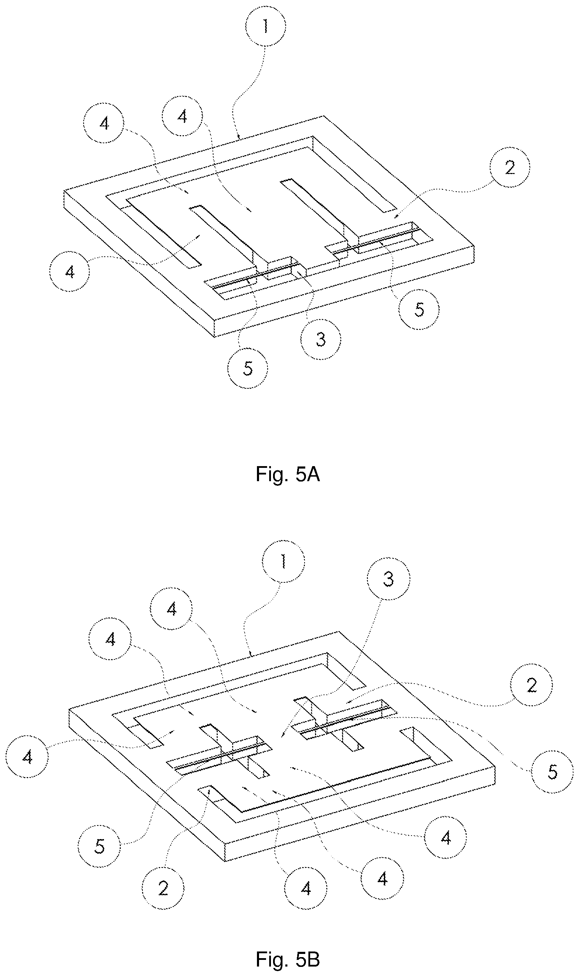

Figure 5A provides a first example of the structure of the invention wherein the cantilever 4 has a zigzag shape, as opposed to the straight configuration of the cantilever 4 as depicted in figures 1 - 4. Also in this embodiment the shuttle 3 is mounted on a cantilever 4 distant from the frame 2, wherein the cantilever 4 is supported by the frame 2. The cantilever 4 with the shuttle 3 is movable transversely to and out of a plane of the frame 2, and the structure 1 further comprises one or more flexures 5 that connect the cantilever 4 with the frame 2. The cantilever 4 has a zig-zag shaped body which at least in part extends eventually in a first direction which points to the shuttle 3. The flexures 5 connect to the shuttle 3, but could also connect to the cantilever 4 in the vicinity of the shuttle 3. Again the flexures 5 are oriented in a second direction that is generally transversely with respect to the first direction, which points to the shuttle 3.

Figure 5B shows a second example of the structure of the invention wherein the cantilever 4 has a zigzag shape body which at least in part eventually extends in a first direction which points to the shuttle 3. In this second example there is a zigzag shaped 'double' cantilever which is mirrored on opposite sides of the flexures 5. Also in this example the flexures 5 are oriented in a second direction that is generally transversely with respect to the first direction of the 'double' cantilever 4, which points to the shuttle 3.

Figure 6 depicts the situation that the structure of the invention is embodied with flexures 5 that are not exactly at right angles but that are oriented in a second direction, which second direction is generally transversely with respect to the first direction in which the cantilever 4, which in this case is tapered, extends from the point where the cantilever 4 connects to the frame 2.

Although the invention has been discussed in the foregoing with reference to an exemplary embodiment of the structure of the invention, the invention is not restricted to this particular embodiment which can be varied in many ways without departing from the invention. The discussed exemplary embodiment shall therefore not be used to construe the appended claims strictly in accordance therewith. On the contrary the embodiment is merely intended to explain the wording of the appended claims without intent to limit the claims to this exemplary embodiment. The scope of protection of the invention shall therefore be construed in accordance with the appended claims only, wherein a possible ambiguity in the wording of the claims shall be resolved using this exemplary embodiment.

## Claims

1. A compliant structure (1) comprising a frame (2), a shuttle (3) distant from the frame (2) mounted on a cantilever (4) that is supported by the frame (2), wherein the cantilever (4) with the shuttle (3) is movable transversely to and out of a plane of the frame (2), and wherein the structure (1) further comprises one or more flexures (5) that connect the cantilever (4) with the frame (2), wherein the cantilever (4) has a body at least in part extending in a first direction which points to the shuttle (3), and that the one or more flexures (5) connect to the shuttle (3) and/or to the cantilever (4) in the vicinity of the shuttle (3), wherein the one or more flexures (5) are oriented in a second direction, which second direction is generally transversely with respect to the first direction, **characterized in that** the one or more flexures (5) are preloaded causing the one or more flexures (5) to buckle so as to provide a selectable stiffness to the cantilever (4) and to provide the cantilever (4) with a preferential position out of the plane of the frame (2).

2. The compliant structure of claim 1, **characterized in that** the one or more flexures (5) are oriented in a second direction that is at right angles with the first direction.

3. The compliant structure of claim 1 or 2, **characterized in that** the structure (1) is a unitary MEMS structure.

4. The compliant structure of any one of claims 1 - 3, **characterized in that** the cantilever (4) is piezoelectric.

5. The compliant structure of any one of claims 1 - 4, **characterized in that** the frame (2) is clamped between a top package element (7) and a bottom package element (8).

6. The compliant structure of any one of the claims 1 - 5, **characterized in that** the structure (1) is embodied as one of an energy harvester, an oscillator, an accelerometer, a geophone, a microphone, a force sensor.

## Patentansprüche

1. Nachgiebige Struktur (1), umfassend einen Rahmen (2), einen vom Rahmen (2) entfernten Ansatz (3), welcher an einem von dem Rahmen (2) getragenen Ausleger (4) angebracht ist, wobei der Ausleger (4) mit dem Ansatz (3) quer zu und aus einer Ebene des Rahmens (2) heraus bewegbar ist, und wobei die Struktur (1) ferner ein oder mehrere Biegeglieder (5) umfasst, welchen den Ausleger (4) mit dem Rahmen (2) verbinden, wobei der Ausleger (4) einen Körper aufweist, welcher sich zumindest teilweise in einer ersten Richtung erstreckt, die auf den Ansatz (3) zeigt, und dass das eine oder die mehreren Biegeglieder (5) mit dem Ansatz (3) und/oder mit dem Ausleger (4) in der Nähe des Ansatzes (3) verbunden sind, wobei das eine oder die mehreren Biegeglieder (5) in einer zweiten Richtung ausgerichtet sind, wobei die zweite Richtung im Wesentlichen quer in Bezug auf die erste Richtung verläuft, **dadurch gekennzeichnet, dass** das eine oder die mehreren Biegeglieder (5) vorgespannt sind, was dazu führt, dass das eine oder die mehreren Biegeglieder (5) sich verbiegen, so dass der Ausleger (4) mit einer wählbaren Steifigkeit versehen ist und der Ausleger (4) mit einer bevorzugten Position außerhalb der Ebene des Rahmens (2) versehen ist.

2. Nachgiebige Struktur nach Anspruch 1, **dadurch gekennzeichnet, dass** das eine oder die mehreren Biegeglieder (5) in einer zweiten Richtung ausgerichtet sind, die im rechten Winkel zu der ersten Richtung verläuft.

3. Nachgiebige Struktur nach Anspruch 1 oder 2, **dadurch gekennzeichnet, dass** die Struktur (1) eine einheitliche MEMS-Struktur ist.

4. Nachgiebige Struktur nach einem der Ansprüche 1 bis 3, **dadurch gekennzeichnet, dass** der Ausleger (4) piezoelektrisch ist.

5. Nachgiebige Struktur nach einem der Ansprüche 1 bis 4, **dadurch gekennzeichnet, dass** der Rahmen (2) zwischen einem oberen Gehäuseelement (7) und einem unteren Gehäuseelement (8) eingespannt ist.

6. Nachgiebige Struktur nach einem der Ansprüche 1 bis 5, **dadurch gekennzeichnet, dass** die Struktur (1) als ein Energie-Ernter, ein Oszillator, ein Beschleunigungsmesser, ein Geophone, ein Mikrofon oder ein Kraftsensor ausgebildet ist.

## Revendications

1. Structure souple (1) comprenant un cadre (2), une navette (3) distante du cadre (2) montée sur un porte-à-faux (4) qui est porté par le cadre (2), dans laquelle le porte-à-faux (4) doté de la navette (3) est mobile transversalement à et hors d'un plan du cadre (2), et dans laquelle la structure (1) comprend en outre un ou plusieurs éléments flexibles (5) qui relient le porte-à-faux (4) au cadre (2), dans laquelle le porte-à-faux (4) possède un corps s'étendant au moins en partie dans une première direction qui pointe vers la navette (3), et que les un ou plusieurs éléments flexibles (5) relient à la navette (3) et/ou au porte-à-faux (4) au voisinage de la navette (3), dans laquelle les un ou plusieurs éléments flexibles (5) sont orientés dans une seconde direction, laquelle seconde direction est généralement de manière transversale par rapport à la première direction, **caractérisée en ce que** les un ou plusieurs éléments flexibles (5) sont précontraints ce qui amène les un ou plusieurs éléments flexibles (5) à se déformer de façon à fournir une rigidité apte à être sélectionnée au porte-à-faux (4) et à fournir au porte-à-faux (4) une position préférentielle hors du plan du cadre (2).

2. Structure souple selon la revendication 1, **caractérisée en ce que** les un ou plusieurs éléments flexibles (5) sont orientés dans une seconde direction qui est à angle droit par rapport à la première direction.

3. Structure souple selon la revendication 1 ou 2, **caractérisée en ce que** la structure (1) est une structure de système microélectromécanique, MEMS, unitaire.

4. Structure souple selon l'une quelconque des revendications 1 à 3, **caractérisée en ce que** le porte-à-faux (4) est piézoélectrique.

5. Structure souple selon l'une quelconque des revendications 1 à 4 **caractérisée en ce que** le cadre (2) est serré entre un élément de boîtier supérieur (7) et un élément de boîtier inférieur (8).

6. Structure souple selon l'une quelconque des revendications 1 à 5, **caractérisée en ce que** la structure (1) est réalisée sous la forme de l'un parmi un collecteur d'énergie, un oscillateur, un accéléromètre, un géophone, un microphone, un capteur de force.
